# EUROPÄISCHE PATENTSCHRIFT

(11) **EP 0 993 966 B1**
(45) Veröffentlichungstag und Bekanntmachung des Hinweises auf die Patenterteilung: **14.05.2003**
(21) Anmeldenummer: 99119798.9
(22) Anmeldetag: 06.10.1999
(51) Int. Cl.: B41M 5/36, G03F 3/10

(54) **Negativ arbeitendes, strahlungsempfindliches Gemisch zur Herstellung eines mit Wärme oder Infrarotlaser bebilderbaren Aufzeichnungsmaterials**
Negativ-working radiation-sensitive mixture for the production of a recording material which is imageable by heat or infrared laser beams
Mélange sensible aux radiations, de type négatif pour la fabrication d'un support d'enregistrement permettant la formation d'images par la chaleur ou sous l'action de rayons lasers infrarouges

(30) Priorität: 13.10.1998 DE 19847033
(43) Veröffentlichungstag der Anmeldung: 19.04.2000
(73) Patentinhaber: Agfa-Gevaert naamloze vennootschap, 2640 Mortsel (BE)
(72) Erfinder: Benzing, Martin, Dr., 55234 Biebelnheim (DE); Mohr, Dieter, Dr., 55437 Appenheim (DE); Schembs, Holger, 55124 Mainz (DE); Clausen, Daniela, 65205 Wiesbaden (DE)
(74) Vertreter: Van Ostaeyen, Marc Albert Jozef

(56) Entgegenhaltungen:
- EP-A- 0 519 591
- EP-A- 0 740 208
- EP-A- 0 750 230
- EP-A- 0 772 089

## Beschreibung

Die Erfindung betrifft ein negativ arbeitendes, für Infrarot- oder Wärmestrahlung empfindliches Gemisch, das ein polymeres Bindemittel und eine Substanz, die infrarote Strahlung in Wärme umwandelt, enthält, sowie ein Aufzeichnungsmaterial mit einem Träger und einer Schicht aus diesem Gemisch. Je nach Wahl des Trägers lassen sich nach der Bebilderung, die beispielsweise mit einem Infrarot-Laser erfolgen kann, aus dem Aufzeichnungsmaterial unter anderem Offsetdruckplatten oder Farbprüffolien (Color-Proofs) herstellen.

Bei der Bebilderung mit Infrarotlasern oder Thermoköpfen kommen negativ arbeitende Schichten in der Regel mit wesentlich kürzeren Belichtungszeiten aus als positiv arbeitende. Dennoch ist bisher nur eine geringe Anzahl an Aufzeichnungsmaterialien mit einer negativ arbeitenden, infrarot oder thermisch bebilderbaren Schicht bekannt geworden.

So ist in der EP-A 0 780 239 ein Aufzeichnungsmaterial für die Herstellung von Offsetdruckplatten offenbart, dessen negativ arbeitende Schicht im wesentlichen aus einer Substanz, die infrarote Strahlung in Wärme umwandelt, einem wasserunlöslichen, in wäßrig-alkalischem Medium dagegen löslichen polymeren Bindemittel sowie einem Phenolderivat besteht. Das Phenolderivat enthält 4 bis 8 Benzolkerne, mindestens eine phenolische Hydroxylgruppe und mindestens zwei Gruppen der Formel -CH₂OR¹, wobei R¹ ein Wasserstoffatom, eine Alkyl- oder eine Acylgruppe darstellt. Als Bindemittel sind Harze mit phenolischen Hydroxylgruppen oder mit olefinisch ungesättigten Bindungen bevorzugt. Speziell genannt sind Novolakharze, Polyhydroxystyrole, Acrylharze mit phenolischen Gruppen und Allylmethacrylat-Copolymere. Nach der Infrarot-Bebilderung wird das Aufzeichnungsmaterial mit einer wäßrig-alkalischen Lösung entwickelt.

Auch in der EP-A 0 557 138 sind thermosensitive, negativ arbeitende, strahlungsempfindliche Gemische beschrieben. In einer Ausführungsform enthalten sie ein Polymer, insbesondere ein Epoxyharz, ein Epoxy-Novolakharz oder ein aliphatisches, aromatisches oder heteroaromatisches Polyaminharz, ein Vernetzungsmittel und eine Säure oder eine Verbindung, die beim Erhitzen eine Säure freisetzt. Als Vernetzungsmittel sind Diethylentriamin, Triethylentetramin, Diethylenpropylamin, *ortho*-, *meta*- und *para*-Phenylendiamin, Bis-(4-aminophenyl)-methan und 2-Methyl-imidazol genannt. In der zweiten Ausführungsform enthält das Gemisch als wesentliche Bestandteile einen Novolak, einen Photoinitiator, der bei Bestrahlung Säure produziert, und ein Vernetzungsmittel, das beim Erhitzen in Gegenwart von Säure mit dem Novolak reagiert. Der Photoinitiator ist beispielsweise ein *ortho*-Nitro-benzaldehyd, ein Ester oder ein Amid der 1,2-Naphthochinon-2-diazid-4-sulfonsäure oder ein Oniumsalz. Bei Verwendung dieses Gemisches wird das Aufzeichnungsmaterial zunächst vollflächig belichtet, damit überall in der strahlungsempfindlichen Schicht Säure gebildet wird. Durch gezielt einwirkende Hitze wird dann die thermisch induzierte Vemetzung ausgelöst. Die nicht erhitzten Bereiche der Schicht werden dann mit einem wäßrigen Entwickler entfernt. Zum bildmäßigen Erhitzen wird bevorzugt eine Infrarot-Laserdiode, ein CO₂-Laser oder ein Nd-YAG-Laser (1060 nm) eingesetzt. Die Gemische dienen in erster Linie zur Herstellung von gedruckten Schaltungen.

Das thermisch bebilderbare Aufzeichnungsmaterial gemäß der EP-A 615 162 umfaßt einen dimensionsstabilen Träger und eine Schicht, die ein kationisches Polymer mit seitenständigen Ammoniumgruppen der Formel -NR¹R²R³R^{4 +} X⁻ (R = H, Alkyl, Alkenyl oder Aryl), ein IR-absorbierendes Material und einen Farbstoff enthält. Bebildert wird das Material allgemein mit einem Infrarot-Laser oder mit Laserdioden (750 bis 880 nm). Die nicht von der Laserstrahlung getroffenen Bereiche der Schicht werden dann mit einfachem Leitungswasser oder mit einer wäßrigen Lösung entfernt. Das Aufzeichnungsmaterial ist in erster Linie vorgesehen zur Herstellung von Color-Proofs. Der Träger ist dann eine transparente Folie. Werden Bilder in den verschiedenen Grundfarben (gelb, magenta, cyan und schwarz) übereinander angeordnet, so erhält man einen mehrfarbigen Color-Proof. Bei der Herstellung von Offsetdruckplatten besteht der Träger dagegen allgemein aus Metallen, wie Aluminium, bei der Herstellung von gedruckten Schaltungen schließlich aus Papier, das mit Phenolharzen oder Epoxyharzen imprägniert ist, aus Polyester, Polyimid oder Polystyrol.

In der US-A 4 693 958 ist ein Aufzeichnungsmaterial beschrieben, aus dem sich Offsetdruckplatten herstellen lassen. Es umfaßt eine Schicht, die durch Infrarotstrahlung, beispielsweise aus einem Nd-YAG-Laser (1060 nm), gehärtet werden kann. Die Schicht besteht aus einem wasserlöslichen, zumindest aber hydrophilen Polyamid, einem Polymer mit seitenständigen quartären Ammoniumgruppen oder einem Styrol/Vinylpyrrolidon-Copolymer. Die gehärteten Bereiche der Schicht sind unlöslich in Wasser und nehmen später die Druckfarbe an. Die nicht von der Infrarotstrahlung getroffenen Bereiche der Schicht werden dementsprechend mit Wasser oder einer wäßrig-alkalischen Entwicklerlösung entfernt.

Neben diesen direkt negativ arbeitenden Systemen sind auch Positiv-Negativ-Umkehrsysteme bekannt. Darin wird erst durch einen zusätzlichen Verarbeitungsschritt, insbesondere eine Nacherwärmung, ein negatives Bild aus einem eigentlich positiv arbeitenden Material erhalten. Beispiele dafür sind in den US-A 5 372 907, 5 466 557 und 5 491 046 beschrieben, bei denen Schichten, die ein Resolharz, ein Novolakharz, eine latente Brönsted-Säure und einen Infrarotabsorber enthalten, mit Infrarotstrahlung (830 nm) bebildert werden.

Unmittelbar negativ arbeitende Systeme sind aufgrund der einfacheren Verarbeitung günstiger. Es bestand daher nach wie vor ein Bedarf an möglichst einfach zusammengesetzten negativ arbeitenden Gemischen. Bei Arbeiten mit verschiedenen Polymeren für Farbprüfsysteme (Color proofs) wurde nun überraschend gefunden, daß Polyvinylacetalharze, die noch freie, nicht acetalisierte Hydroxylgruppen enthalten, die zum Teil mit cyclischen organischen Anhydriden verestert sind, so daß die Harze noch zusätzlich Carboxylgruppen enthalten, nach Einwirkung von Wärme eine stark verringerte Löslichkeit in wäßrig-alkalischen Entwicklern zeigen. Der Löslichkeitsunterschied reicht aus, um in einer entsprechenden Aufzeichnungsschicht eine bildmäßige Differenzierung zu bewirken.

Aufgabe der Erfindung war es demnach, ein direkt negativ arbeitendes strahlungsempfindliches Gemisch zu entwickeln sowie ein damit hergestelltes Aufzeichnungsmaterial, das mit Strahlung im infraroten Bereich (700 bis 1.200 nm) bebildert werden kann. Als Strahlungsquellen sollen Laserdioden mit einer Wellenlänge von 830 nm oder Nd-YAG-Laser mit einer Wellenlänge von 1060 nm einsetzbar sein.

Gelöst wird die Aufgabe mit einem negativ arbeitenden, strahlungsempfindlichen Gemisch, das ein polymeres Bindemittel und eine Substanz enthält, die Strahlungsenergie in Wärme umwandelt, und dadurch gekennzeichnet ist, daß das polymere Bindemittel im wesentlichen aus Einheiten der Formel (I) 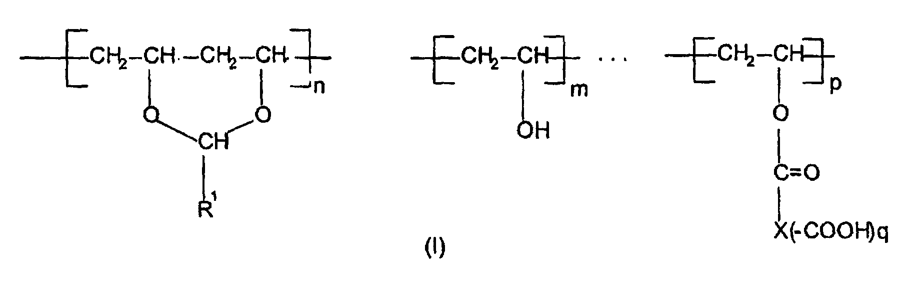 besteht, wobei
- R¹: ein Wasserstoffatom oder einen (C₁-C₄)Alkylrest,
- X: eine Einfachbindung oder einen (q+1)-wertigen Rest eines (C₄-C₁₀)Alkans, in dem einzelne Methylengruppen durch Heteroatome ersetzt sein können, eines (C₂-C₈)Alkens oder eines isocyclischen oder heterocyclischen, gesättigten oder ungesättigten, mono- oder polycyclischen (C₆-C₁₀)Ringes oder Ringsystems,
- n: 40 bis 80 mol-%,
- m: 15 bis 30 mol-%,
- p: 1 bis 10 mol-% und
- q: eine ganze Zahl von 1 bis 3, wobei q gleich 1 ist, wenn X eine Einfachbindung ist,
darstellt und das polymere Bindemittel eine Säurezahl von 5 bis 150 aufweist. Gegenstand der vorliegenden Erfindung ist daneben auch ein Aufzeichnungsmaterial mit einem Träger und einer Schicht aus dem strahlungsempfindlichen Gemisch.

R¹ ist besonders bevorzugt ein Propylrest. X ist bevorzugt eine Einfachbindung, eine Ethan-1,2-diyl-, Propan-1,2-diyl-, Propan-1,3-diyl-, 2-Oxa-propan-1,3-diyl-, 2-Methyl-propan-1,3-diyl-, Butan-1,3-diyl-, Ethen-1,2-diyl-, 1-Methyl-ethen-1,2-diyl-, 1,2-Dimethyl-ethen-1,2-diyl-, 1,2,2-Trimethyl-cyclopentan-1,3-diyl-, Cyclohexen-1,2-diyl-, *ortho*-Phenylen-, Benzol-1,2,4-triyl-, Benzol-1,2,4,5-tetrayl-, Naphthalin-2,3-diyl-, Naphthalin-1,8-diyl-, Naphthalin-1,4,5,8-tetrayl-, Pyridin-2,3-diyl-, Pyrazin-2,3-diyl-, Furan-2,3-diyl-, Furan-2,5-diyl-, Thiophen-2,3-diyl-, Thiophen-2,5-diyl- oder eine Bicyclo[2.2.1]hept-2-en-5,6-diyl-Gruppe. Die Gruppen X können zusätzlich substituiert sein, beispielsweise mit Halogenatomen (Cl, Br), Alkoxygruppen oder Nitrogruppen.

Das mittlere Molekulargewicht M_{w} des Polymers der Formel (I) kann in weiten Grenzen schwanken. Es liegt allgemein bei 5.000 bis 500.000, bevorzugt 20.000 bis 300.000. Die Säurezahlen des Polymers liegen allgemein im Bereich von 5 bis 150, bevorzugt 30 bis 120. Die genannten Monomereinheiten sind in dem Polymer statistisch verteilt, es handelt sich also nicht etwa um ein Blockcopolymer.

Das erfindungsgemäße Gemisch kann gegebenenfalls noch Additive, insbesondere Farbstoffe, Weichmacher, Löslichkeitsinhibitoren, Löslichkeitsbeschleuniger, Reaktionsbeschleuniger, Reste von organischen Lösemitteln, Tenside, Mittel, die für eine gleichmäßig verlaufende Oberfläche der Schicht sorgen, Gleitmittel, Abstandshalter, antistatisch wirkende Mittel und/oder inerte Füllstoffe enthalten. In einer bevorzugten Ausführungsform enthält das Gemisch keine Bestandteile, die für Strahlung mit einer Wellenlänge von 600 nm oder weniger empfindlich sind, so daß bei der Verarbeitung keine besonderen Bedingungen für das Umgebungslicht (wie gelbe oder rote Sicherheitsbeleuchtung) erfüllt sein müssen.

Ausgangsstoffe, aus denen das Polymer der Formel (I) hergestellt werden kann, sind vorzugsweise Polyvinylacetale, die noch freie Hydroxylgruppen enthalten, speziell Polyvinylbutyrale, wie sie unter der Bezeichnung ®Mowital von der Clariant AG oder unter der Bezeichnung ®Butvar von Monsanto Chem. Co. erhältlich sind. Diese können dann verestert werden mit Dicarbonsäureanhydriden, wie Maleinsäureanhydrid, Citraconsäureanhydrid, 2,3-Dimethylmaleinsäureanhydrid, Bernsteinsäureanhydrid, Methylbernsteinsäureanhydrid, Glutarsäureanhydrid, 3-Methyl-glutarsäureanhydrid, Camphersäureanhydrid, Phthalsäureanhydrid, Hexahydrophthalsäureanhydrid, Cyclohexen-1,2-dicarbonsäureanhydrid, Naphthalin-2,3-dicarbonsäureanhydrid, Furan-2,5-dicarbonsäureanhydrid, Trimellitsäureanhydrid oder di- oder polycyclischen Anhydriden, gebildet durch Diels-Alder-Addition von Dienen mit Maleinsäureanhydrid. Auf diese Weise werden Polymere gebildet, die neben freien Hydroxylgruppen auch Carboxylgruppen enthalten. Polymere mit den in der Formel (I) genannten Einheiten sind bekannt. Sie sind ausführlich in der EP-A 152 819 (= US-A 4 631 245) beschrieben, ebenso wie Verfahren zu ihrer Herstellung.

Die als Ausgangsmaterial dienenden Polyvinylacetale werden ihrerseits gewöhnlich aus Polyvinylacetat hergestellt, das unter sauren oder alkalischen Bedingungen verseift und dann unter Wasserabspaltung mit einem Aldehyd acetalisiert wird. Die in dem erfindungsgemäßen Gemisch verwendeten polymeren Bindemittel enthalten daher neben den in der Formel (I) angegebenen Einheiten unvermeidbar einen Restanteil an Polyvinylacetat-Einheiten, der allgemein bis zu etwa 6 mol-%, insbesondere 1 bis 4 mol-%, bezogen auf alle Monomereinheiten im Bindemittel, ausmacht.

Der Anteil dieses Bindemittels beträgt im allgemeinen 30 bis 95, vorzugsweise 45 bis 70 Gew.-%, bezogen auf das Gesamtgewicht der nichtflüchtigen Bestandteile der strahlungsempfindlichen Schicht.

Die Komponente, die IR-Strahlungsenergie in Wärme umzuwandeln vermag, kann ein Rußtyp sein (beispielsweise ®Printex 25 von der Degussa AG) oder auch ein Infrarotabsorber bzw. Infrarotfarbstoff (beispielsweise ®Pro-Jet 830 NP von Zeneca). Zu nennen sind weiterhin Cyaninfarbstoffe, Merocyaninfarbstoffe, Infrarot absorbierende Indoleninfarbstoffe, Indocyaninfarbstoffe, Squaryliumfarbstoffe, Methinfarbstoffe, Cyanfarbstoffe, Pyryliumverbindungen und Pentamethinthiopyryliumsalze. Ruße und Squaryliumfarbstoffe sind allgemein bevorzugt.

In einer besonders bevorzugten Ausführungsform ist das Infrarot absorbierende und Wärme generierende (Farb-)Pigment in einem polymeren Bindemittel mit den in der Formel (I) genannten Einheiten vordispergiert.

Der Anteil der Komponente, die IR-Strahlung in Wärme umwandelt, beträgt allgemein 2 bis 70 Gew.-%, vorzugsweise 30 bis 55 Gew.-%, jeweils bezogen auf das Gesamtgewicht der nichtflüchtigen Bestandteile der strahlungsempfindlichen Schicht.

Gegebenenfalls kann die negativ arbeitende Schicht noch Löslichkeitsinhibitoren enthalten. Dafür eignen sich unter anderem Acrylatpolymere oder andere in wäßrig-alkalischen Lösungen schwer- oder unlösliche Substanzen. Wenn diese Verbindungen im erfindungsgemäßen strahlungsempfindlichen Gemisch eingesetzt werden, so haben sie allgemein einen Anteil von 2 bis 30 Gew.-%, vorzugsweise 4 bis 12 Gew.-%, jeweils bezogen auf das Gewicht der nichtflüchtigen Bestandteile der Schicht.

Daneben kann die Schicht auch Löslichkeitsbeschleuniger enthalten. Geeignete Löslichkeitsbeschleuniger und gleichzeitig auch Reaktionsbeschleuniger sind Säuren wie Phosphorsäure, Trimellitsäure, Nitrobenzolcarbonsäuren oder p-Toluolsulfonsäure, daneben auch Trihalomethyl-s-triazine, Bis-trihalomethyl-s-triazine oder Säurechloride, wie 1,2-Naphthochinon-2-diazid-4-sulfonsäurechlorid und andere. Naphthochinondiazide sind empfindlich gegenüber UV-Strahlung und sichtbarem Licht. Die entsprechenden Aufzeichnungsmaterialien müssen daher bei gelbem Sicherheitslicht verarbeitet werden. Der Anteil dieser nur gegebenenfalls vorhandenen Additive beträgt im allgemeinen 0,5 bis 25 Gew.-%, bevorzugt 2 bis 15 Gew.-%, jeweils bezogen auf das Gesamtgewicht der nichtflüchtigen Bestandteile der strahlungsempfindlichen Schicht.

Zur Herstellung des erfindungsgemäßen Aufzeichnungsmaterials wird das strahlungsempfindliche Gemisch auf einen geeigneten Träger aufgebracht. Allgemein wird das Gemisch dazu in einem Lösemittel, beispielsweise Butanon, Tetrahydrofuran, Propylenglykol-monomethylether oder Propylenglykol-monomethylether-acetat, gelöst und durch Aufgießen, Aufschleudern oder ähnliche Methoden als dünne Schicht auf den Träger aufgebracht. Das Lösemittel wird dann aus der Schicht entfernt, insbesondere durch Anwenden von Hitze und/oder unter vermindertem Druck.

Bevorzugte Träger in strahlungsempfindlichen Aufzeichnungsmaterialien, aus denen Offsetdruckplatten hergestellt werden sollen, sind Bleche, Bänder oder Folien aus Metall, insbesondere aus Aluminium oder einer Aluminiumlegierung, die in allgemein üblicher Weise vorbehandelt sein können. Bei Aluminiumträgern umfaßt eine solche Vorbehandlung insbesondere eine mechanische, chemische oder elektrochemische Aufrauhung, an die sich eine anodische Oxidation und weitere Behandlungen, z. B. mit Polyvinylphosphonsäure, Alkalisilikat, Phosphat oder Polyacrylamid, anschließen können.

In Aufzeichnungsmaterialien zur Herstellung von Farbprüffolien dient allgemein eine transparente, flexible und dimensionsstabile Kunststoffolie, insbesondere eine Folie aus Polyester oder Polycarbonat, als Trägermaterial. Bevorzugt sind Polyesterfolien, insbesondere biaxial verstreckte und thermofixierte Folien, z. B. aus Polyethylenterephthalat (PET). Die Folien sind so gewählt, daß sie bei Temperaturen bis zu etwa 150 °C maßhaltig bleiben. Ihre Dicke beträgt im allgemeinen 10 bis 200 µm, vorzugsweise 20 bis 80 µm.

Die bildmäßige Bestrahlung erfolgt vorzugsweise mit IR-Lasern oder IR-Laserdioden, die Strahlung mit einer Wellenlänge im Bereich von 700 bis 1200 nm, bevorzugt 750 bis 1100 nm, aussenden. Bestrahlt werden kann das Aufzeichnungsmaterial in einem Flachbettbelichter sowie einem Außen- oder Innentrommelbelichter.

Anschließend werden die unbelichteten Schichtbereiche mit einem geeigneten flüssigen Entwickler entfernt. Als Entwicklerlösungen werden allgemein wäßrigalkalische Lösungen mit einem pH-Wert im Bereich von 8 bis 14, vorzugsweise 9 bis 11, verwendet, die Puffersalze, beispielsweise wasserlösliche Alkaliphosphate, -silikate, -borate, -carbonate, -acetate oder -benzoate enthalten können. Als weitere Bestandteile können darin Netzmittel und geringe Mengen an mit Wasser mischbaren organischen Lösemitteln vorhanden sein.

Als Alternative zur Naßentwicklung kann auf die bildmäßig bestrahlte lichtempfindliche Schicht eine Entwicklungsfolie laminiert werden. Die nicht bestrahlten Bereiche der Schicht haften an der Folie stärker als die bestrahlten, beim Abziehen der Folie (peel-apart) werden daher nur diese Bereiche mitentfernt. Das Peel-apart-Verfahren hat den Vorteil, daß keinerlei flüssige Abfallprodukte anfallen.

Gegenstand der vorliegenden Erfindung ist schließlich auch ein Verfahren zur Herstellung einer Farbprüffolie mit den Schritten
(a) Zurverfügungstellen eines Materials mit einem UVNIS-transparenten Träger, einer darauf befindlichen photopolymerisierbaren Schicht, die mit Farbstoffen oder Pigmenten in einer Grundfarbe eingefärbt ist, und einer auf dieser Schicht befindlichen Haftschicht,
(b) Aufbringen der erfindungsgemäßen thermosensitiven Schicht auf die Rückseite des transparenten Trägers,
(c) Auflaminieren des so hergestellten Mehrschichtmaterials auf ein Bildempfangsblatt, wobei die Haftschicht dem Bildempfangsblatt zugewandt ist,
(d) bildmäßiges Bestrahlen der thermosensitiven Schicht mit IR-Strahlung,
(e) Ausbilden einer Belichtungsmaske durch Entfernen der nichtbestrahlten Bereiche der thermosensitiven Schicht,
(f) ganzflächiges Bestrahlen mit UV/VIS-Strahlung durch die Belichtungsmaske und
(g) Abziehen des transparenten Trägers mit der Maske und den bestrahlten und daher polymerisierten Bereichen der photopolymerisierbaren Schicht und gegebenenfalls
(h) Wiederholen der Schritte (a) bis (g) mit einem Material, dessen photopolymerisierbare Schicht in einer anderen Grundfarbe eingefärbt ist, wobei dieses auf das bereits ein Teilfarbenbild tragende Bildempfangsblatt auflaminiert wird.

Der für UV- bzw. sichtbares Licht transparente, dimensionsstabile Träger ist vorzugsweise eine biaxial verstreckte und thermofixierte Kunststoffolie, insbesondere eine Polyesterfolie. Auf einer Seite ist der Träger zweckmäßig haftvermittelnd vorbehandelt. Die auf der haftvermittelnd vorbehandelten Seite des Trägers angeordnete photopolymerisierbare Schicht ist jeweils in einer Grundfarbe (gelb, magenta, cyan oder schwarz) eingefärbt. Nach dem Entfernen des Beschichtungslösemittels (allgemein durch Erhitzen auf Temperaturen bis etwa 120 °C) beträgt das Gewicht der photopolymerisierbaren Schicht üblicherweise etwa 0,2 bis 5,0 g/m², bevorzugt 0,3 bis 3,0 g/m². Anschließend wird eine - bevorzugt wäßrige - Haftschichtlösung auf die photopolymerisierbare Schicht aufgetragen und erneut getrocknet. Nach dem Trocknen liegt das Gewicht der Haftschicht bei etwa 2 bis 30 g/m². Geeignete Gemische für die photopolymerisierbare Schicht wie auch für die darüber liegende Haftschicht sind bekannt und beispielsweise in der EP-A 803 773, der US-A 4 895 787 oder der US-A 5 049 476 beschrieben. Das erfindungsgemäße, thermosensitive Gemisch wird dann auf die Rückseite des Trägers aufgebracht, beispielsweise mit Hilfe eines Rakels, und das Beschichtungslösemittel entfernt. Das so hergestellte Mehrschichtmaterial wird dann über die Haftschicht auf ein Bildempfangsmaterial laminiert. Von der Seite der thermosensitiven Schicht her läßt man anschließend IR-Laserstrahlung bildmäßig auf die Schicht einwirken und entwickelt sodann. Die Entwicklung kann, wie beschrieben, mit einem flüssigen Entwickler oder durch ein Peel-apart-Verfahren mit Hilfe einer Entwicklungsfolie erfolgen. Die bestrahlten Bereiche der thermosensitiven Schicht bleiben danach zurück und formen ein Bild auf der Rückseite des transparenten Trägers. Dieses Bild dient als Belichtungsmaske bei der nachfolgenden ganzflächigen UV/VIS-Belichtung. An den nicht von der Maske abgedeckten Bereichen dringt die UVNIS-Strahlung durch den transparenten Träger und löst die Polymerisation in der photopolymerisierbaren, in der jeweiligen Farbe eingefärbten Schicht aus. Der transparente Träger mitsamt der Maske und den polymerisierten Bereichen der photopolymerisierbaren Schicht werden dann abgezogen. Zurück bleibt ein farbiges Bild auf dem Bildempfangsmaterial.

Auf dieses farbige Bild kann wiederum ein Aufzeichnungsmaterial der genannten Art laminiert werden, dessen photopolymerisierbare Schicht in einer anderen Grundfarbe eingefärbt ist. Nach digital gesteuerter bildmäßiger IR-Bestrahlung, Entwicklung der thermosensitiven Schicht, gefolgt von vollflächiger UV/VIS-Belichtung und Abziehen des Trägers mit Maske und den polymerisierten Bereichen der in der anderen Grundfarbe eingefärbten photopolymerisierbaren Schicht entsteht ein zweifarbiges Bild auf dem Bildempfangsmaterial. Der Vorgang kann wiederholt werden, bis ein vollständiges Farbprüfbild aus allen Teilfarbenbildern entstanden ist.

Die Erfindung wird durch nachstehende Beispiele näher erläutert, ohne sie hierauf zu beschränken. Sofern nicht anders angegeben, sind alle Prozentangaben und Mengenverhältnisse in Gewichtseinheiten zu verstehen. Gt steht für Gewichtsteil(e).

### Beispiel 1

### A: Herstellung eines für das erfindungsgemäße strahlungsempfindliche Gemisch geeigneten polymeren Bindemittels

25 Gt eines Polyvinylbutyrals mit einem Molekulargewicht M_{w} von etwa 170.000 bis 180.000, das ca. 70 % Vinylbutyral-, 3 % Vinylacetat- und 27 % Vinylalkoholeinheiten enthält, und 4 Gt Maleinsäureanhydrid wurden unter Erwärmen in 400 Gt Methylethylketon gelöst. Zur klaren Lösung wurde 1 Gt Triethylamin gegeben und die Lösung 5 h unter Rückfluß erhitzt. Nach dem Abkühlen wurde die Lösung filtriert und in 6.000 Gt entmineralisiertes Wasser eingetropft, wobei ein weißes, faseriges Produkt entstand, das abgesaugt und bis zur Gewichtskonstanz im Vakuum bei 40 °C getrocknet wurde.

### B: Herstellung einer Rußdispersion

20 Gt des Polymeren aus Abschnitt **A** wurden in 160 Gt 1-Methoxy-2-propanol (= Propylenglykol-monomethylether) gelöst und in ein Dispergiergefäß geeigneter Größe gegeben. In diese Lösung wurden mit einer Zackenscheibe 20 Gt Ruß (®Printex 25 der Degussa AG) eingerührt. Danach wurden 180 Gt Glaskugeln (Durchmesser ca. 1 mm) zugegeben und mit einer Mahlscheibe unter Kühlung bei ca. 5.000 Umdrehungen pro min etwa 7 Stunden lang dispergiert. Anschließend wurden die Glaskugeln von dem fertigen Produkt durch Filtration abgetrennt.

### C: Herstellung eines Aufzeichnungsmaterials

Zur Herstellung des erfindungsgemäßen Aufzeichnungsmaterials wurde eine Mischung aus 15 Gt Rußdispersion (hergestellt wie unter **B**) beschrieben), 57 Gt 1-Methoxy-2-propanol und 28 Gt Methylethylketon bei ca. 110 Umdrehungen pro min auf ein aufgerauhtes, anodisiertes und hydrophiliertes Aluminiumblech aufgeschleudert. Danach wurde das so hergestellte Aufzeichnungsmaterial 1 min bei 100 °C im Trockenschrank getrocknet. Das Gewicht der strahlungsempfindlichen Schicht betrug ca. 1 g/m².

### D: Verarbeitung des Aufzeichnungsmaterials

Belichtet wurde das Aufzeichnungsmaterial aus Abschnitt **C** in einem Laserbelichter Creo Trendsetter mit Thermokopf (Laserdiode 830 nm) mit einer Leistung von 8 W bei 50 Umdrehungen pro min, was einer Energieübertragung von etwa 500 mJ/cm² entsprach.

Die Entwicklung erfolgte dann in einer Küvette mit einem handelsüblichen Negativentwickler ®Ozasol EN 232 (pH-Wert ca. 9), der 10 s lang auf die bildmäßig bestrahlte Schicht einwirkte. Danach wurde das Material mit einem Wattepad abgerieben und mit Wasser abgespült. Auf diese Weise entstand ein negatives Bild. Die Entwicklerresistenz der ausbelichteten Schicht war jedoch relativ niedrig.

### Beispiel 2

Beispiel 1 wurde wiederholt mit der Abweichung, daß der Träger diesmal mit einem Gemisch aus

| | |
|---|---|
| 13,7 Gt | Rußdispersion (wie im Beispiel 1, Abschnitt B), beschrieben), |
| 0,3 Gt | 1,2-Naphthochinon-(2)-diazid-4-sulfonsäurechlorid, |
| 58,0 Gt | 1-Methoxy-2-propanol und |
| 28,0 Gt | Methylethylketon |

beschichtet wurde. Nach der bildmäßigen Wärmeeinwirkung entstand wiederum ein negatives Bild, die Entwicklerresistenz der ausbelichteten Schicht war besser als im Beispiel 1.

### Beispiel 3

Es wurde gearbeitet wie in Beispiel 1, jedoch wurde eine Beschichtungslösung aus

| | |
|---|---|
| 1,50 Gt | Rußdispersion (wie in Beispiel 1 beschrieben), |
| 2,64 Gt | Polymer **A** (wie in Beispiel 1 beschrieben), |
| 0,06 Gt | *para*-Toluolsulfonsäure, |
| 67,80 Gt | 1-Methoxy-2-propanol und |
| 28,00 Gt | Methylethylketon |

eingesetzt. Nach der bildmäßigen Einwirkung von Wärme entstand ein negatives Bild. Die Entwicklerresistenz der bestrahlten Schicht war vergleichbar mit der im Beispiel 2.

### Beispiel 4

Es wurde gearbeitet wie in Beispiel 1, es wurde jedoch eine Beschichtungslösung aus

| | |
|---|---|
| 0,15 Gt | ®Pro-Jet 830 NP (Fa. Zeneca), |
| 2,49 Gt | Polymer **A** (aus Bsp. 1), |
| 0,30 Gt | 1,2-Naphthochinon-2-diazid-4-sulfonsäurechlorid, |
| 0,06 Gt | Phosphorsäure, |
| 69,00 Gt | 1-Methoxy-2-propanol und |
| 28,00 Gt | Methylethylketon |

verwendet. Es entstand ein negatives Bild. Die Entwicklerresistenz entsprach der im Beispiel 2.

### Beispiel 5

### E: Herstellung eines weiteren, für das erfindungsgemäße strahlungsempfindliche Gemisch geeigneten polymeren Bindemittels

Analog Beispiel 1, Abschnitt A wurde ein polymeres Bindemittel hergestellt. Als Ausgangsmaterialien wurden jedoch ein Polyvinylbutyral mit einem geringeren Molekulargewicht (M_{w} ca. 70.000 bis 80.000) und Trimellitsäureanhydrid anstelle von Maleinsäureanhydrid eingesetzt.

Beispiel 1 wurde wiederholt, beschichtet wurde jedoch mit folgender Lösung:

| | |
|---|---|
| 6,00 Gt | Rußdispersion **B** (aus Bsp. 1), |
| 1,74 Gt | Polymer **E,** |
| 0,06 Gt | p-Toluolsulfonsäure, |
| 64,20 Gt | 1-Methoxy-2-propanol und |
| 28,00 Gt | Methylethylketon. |

Es entstand ein negatives Bild. Bei der Entwicklung mußte nach der Einwirkzeit nicht gerieben, sondern nur abgespült werden. Die Entwicklerresistenz entsprach der gemäß Beispiel 2.

### Beispiel 6

### Anwendung des erfindungsgemäßen Gemisches in einem Farbprüfsystem

Die Ausgangsmaterialien entsprechen den Farbprüffolien aus EP-A 0 803 773 oder auch US-A 4 895 787 und 5 049 476, die ein analog arbeitendes Farbprüfsystem darstellen.

In Kombination mit dem erfindungsgemäßen strahlungsempfindlichen Gemisch erhält man ein thermisch digital bebilderbares Farbprüfsystem.

### Ausgangsmaterialien:

Auf 50 µm dicke, einseitig haftvermittelnd vorbehandelte, biaxial verstreckte und thermofixierte Polyesterfolien (®Melinex 457) wurde jeweils eines der folgenden Gemische aufgebracht:

| Bestandteile | Cyan | Magenta | Gelb | Schwarz |
|---|---|---|---|---|
| Dipentaerythrit-pentaacrylat | 19,9 | 25,0 | 21,6 | 19,9 |
| 2,4-Bis-trichlormethyl-6-biphenyl-4-yl-s-triazin | 5,1 | 6,1 | 5,4 | 5,3 |
| Polyvinylformal (®Formvar 12/85) | 16,3 | 23,0 | 18,4 | 14,2 |
| Mischpolymerisat eines polyethermodifizierten Polysiloxans mit 80 Gew.-% Ethylenoxid- und 20 Gew.-% Propylenoxid-Einheiten im Polyetheranteil; Viskosität 240 cSt/25°C, Mw ca. 6.500 | 0,2 | 0,2 | 0,2 | 0,2 |
| ®Hostaperm Blau B2G (C.I. 74 160) | 9,7 | | | |
| Permanent Red FBB (C.I. 12 485) | | 12,9 | | |
| Permanent Yellow GR (C.I. 21 100) | | | 8,6 | |
| Ruß (®Printex 25) | | | | 13.6 |
| Tetrahydrofuran | 398,6 | 363,9 | 382,4 | 378,8 |
| 4-Hydroxy-4-methyl-2-pentanon | 113,9 | 121,3 | 124,3 | 123,1 |
| 1-Methoxy-2-propanol | 360,6 | 326,5 | 353,7 | 331,5 |
| γ-Butyrolacton | 75,9 | 121,3 | 86,0 | 113,6 |

Die Pigmente wurden mit einem Teil des Bindemittels und dem γ-Butyrolacton dispergiert. Die mittlere Teilchengröße lag unterhalb von 200 nm.

Die beschichteten Folien wurden im Trockenkanal bei Temperaturen bis 110 °C getrocknet. Das Schichtgewicht lag zwischen 0,6 und 0,8 g/m².

Auf die trockene photopolymerisierbare Schicht wurde folgende Haftschichtlösung aufgebracht:

| | |
|---|---|
| 50,0 Gt | Vinylacetat/Crotonsäure-Copolymeres 95:5, |
| 0,16 Gt | Pyrogene Kieselsäure (mittl. Teilchengröße 40 nm), |
| 252 Gt | Wasser, |
| 24,0 Gt | Ethanol und |
| 5,0 Gt | Ammoniakwasser, 25 %-ig. |

Die beschichteten Folien wurden im Trockenkanal bei Temperaturen von 100 °C getrocknet. Das Schichtgewicht betrug 6,5 g/m².

### Beschichtung des erfindungsgemäßen strahlungsempfindlichen Gemisches:

Auf die Rückseite dieser Farbprüffolien wurde nun folgende Beschichtungslösung mittels eines Rakelgerätes aufgebracht und 1 min bei ca. 100 °C im Trockenschrank getrocknet (Schichtgewicht danach ca. 1,4 g/m²):

| | |
|---|---|
| 31,20 Gt | Rußdispersion **B** (aus Beispiel 1), |
| 0,96 Gt | Polymer **E** (aus Beispiel 5), |
| 0,16 Gt | *para*-Toluolsulfonsäure, |
| 0,64 Gt | ®Tint-Ayd PC 9298 (von Daniel Products), |
| 37,34 Gt | 1-Methoxy-2-propanol und |
| 29,70 Gt | Methylethylketon |

### Verarbeitung des fertigen Aufzeichnungsmaterials:

a) Ein Aufzeichnungsmaterial der Farbe Cyan wurde über die Haftschicht auf ein Trägermaterial auflaminiert.
b) Danach wurde in einem Laserbelichter Creo Trendsetter mit Thermokopf (Laserdiode 830 nm) mit einer Leistung von 8 W bei 50 Umdrehungen pro min belichtet, was einer Energieübertragung von ca. 500 mJ/cm² entspricht.
c) Anschließend wurde mit einem handelsüblichen Negativentwickler ®Ozasol EN 232, der einen pH-Wert von ca. 9 besitzt, etwa 10 s lang entwickelt, danach mit einem Wattepad abgerieben und mit Wasser abgespült.
   Es entstand ein negatives Bild als Maske auf der Farbprüffolie. Die Entwicklerresistenz der ausbelichteten Schicht war im Vergleich zu den voranstehenden Beispielen sehr gut.
   Alternativ konnte eine Entwicklung außer durch den flüssigen Entwickler auch durch Aufbringen und Wiederabziehen von Klebefolien erreicht werden (Peel-apart-Verfahren).
d) Nach der Entwicklung des digital belichteten Bildes wurde durch die nun entstandene schwarze Maske mit UV-Licht (1000 W, ca. 20 s) flutbelichtet und die Polyesterfolie zusammen mit der Maske und den Nichtbildstellen der in Farbe Cyan eingefärbten photopolymerisierbaren Schicht abgezogen.
   Man erhielt ein Bild der Farbe Cyan, welches dem digital belichteten Muster entsprach.

Durch Wiederholung der Schritte a) bis d) mit den anderen Prozeßfarben Magenta, Gelb und Schwarz unter Verwendung der entsprechenden digitalen Belichtungsdaten und Flutbelichtungszeiten konnte auf diese Weise ein thermisch digital belichtetes Farbprüfbild erhalten werden.

## Patentansprüche

1. Negativ arbeitendes, strahlungsempfindliches Gemisch, das ein organisches polymeres Bindemittel und eine Substanz, die Strahlungsenergie in Wärme umwandelt, enthält, **dadurch gekennzeichnet, daß** das polymere Bindemittel im wesentlichen aus Einheiten der Formel (I) 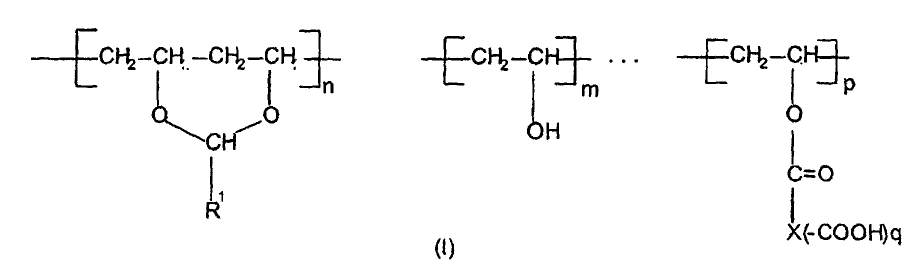 besteht, wobei
R¹ ein Wasserstoffatom oder einen (C₁-C₄)Alkylrest,
X eine Einfachbindung oder einen (q+1)-wertigen Rest eines (C₄-C₁₀) Alkans, in dem einzelne Methylengruppen durch Heteroatome ersetzt sein können, eines (C₂-C₈)Alkens oder eines isocyclischen oder heterocyclischen, gesättigten oder ungesättigten, mono- oder polycyclischen (C₆-C₁₀)Ringes oder Ringsystems,
n 40 bis 80 mol-%,
m 15 bis 30 mol-%,
p 1 bis 10 mol-% und
q eine ganze Zahl von 1 bis 3, wobei q gleich 1 ist, wenn X eine Einfachbindung ist,
darstellt und das polymere Bindemittel eine Säurezahl von 5 bis 150 aufweist.

2. Strahlungsempfindliches Gemisch nach Anspruch 1, **dadurch gekennzeichnet, daß** das mittlere Molekulargewicht M_{w} des Polymers der Formel (I) bei 5.000 bis 500.000, bevorzugt bei 20.000 bis 300.000 liegt.

3. Strahlungsempfindliches Gemisch nach Anspruch 1, **dadurch gekennzeichnet, daß** das polymere Bindemittel einen Restanteil an Polyvinylacetat-Einheiten enthält, der allgemein bis zu etwa 6 mol-%, insbesondere 1 bis 4 mol-%, bezogen auf alle Monomereinheiten im Bindemittel, ausmacht.

4. Strahlungsempfindliches Gemisch nach Anspruch 1, **dadurch gekennzeichnet, daß** der Anteil des Bindemittels im allgemeinen 30 bis 95, vorzugsweise 45 bis 70 Gew.-%, bezogen auf das Gesamtgewicht der nichtflüchtigen Bestandteile der strahlungsempfindlichen Schicht, beträgt.

5. Strahlungsempfindliches Gemisch nach Anspruch 1, **dadurch gekennzeichnet, daß** die Komponente, die IR-Strahlungsenergie in Wärme umzuwandeln vermag, Ruß, ein Cyaninfarbstoff, Merocyaninfarbstoff, ein Infrarot absorbierender Indoleninfarbstoff, Indocyaninfarbstoff, Squaryliumfarbstoff, Methinfarbstoff, Cyanfarbstoff, eine Pyryliumverbindung oder ein Pentamethinthiopyryliumsalz ist.

6. Strahlungsempfindliches Gemisch nach Anspruch 5, **dadurch gekennzeichnet, daß** das Infrarot absorbierende und Wärme generierende (Farb-)Pigment in einem polymeren Bindemittel mit den in der Formel (I) genannten Einheiten vordispergiert ist.

7. Strahlungsempfindliches Gemisch nach Anspruch 5, **dadurch gekennzeichnet, daß** der Anteil der Komponente, die IR-Strahlung in Wärme umwandelt, allgemein 2 bis 70 Gew.-%, vorzugsweise 30 bis 55 Gew.-%, jeweils bezogen auf das Gesamtgewicht der nichtflüchtigen Bestandteile der strahlungsempfindlichen Schicht, beträgt.

8. Strahlungsempfindliches Gemisch nach Anspruch 1, **dadurch gekennzeichnet, daß** es ggf. Löslichkeitsinhibitoren in einem Anteil von 2 bis 30 Gew.-%, vorzugsweise 4 bis 12 Gew.-%, jeweils bezogen auf das Gewicht der nichtflüchtigen Bestandteile der Schicht, enthält.

9. Strahlungsempfindliches Gemisch nach Anspruch 1, **dadurch gekennzeichnet, daß** es als Löslichkeitsbeschleuniger und Reaktionsbeschleuniger Säuren wie Phosphorsäure, Trimellitsäure, Nitrobenzolcarbonsäuren oder p-Toluolsulfonsäure, daneben auch Trihalomethyl-s-triazine, Bis-trihalomethyl-s-triazine oder Säurechloride, wie 1,2-Naphthochinon-2-diazid-4-sulfonsäurechlorid in einem Anteil von 0,5 bis 25 Gew.-%, bevorzugt 2 bis 15 Gew.-%, jeweils bezogen auf das Gesamtgewicht der nichtflüchtigen Bestandteile der strahlungsempfindlichen Schicht, enthält.

10. Aufzeichnungsmaterial mit einem Träger und einer strahlungsempfindlichen Schicht, **dadurch gekennzeichnet, daß** die Schicht aus einem Gemisch gemäß einem oder mehreren der Ansprüche 1 bis 9 besteht.

11. Aufzeichnungsmaterial nach Anspruch 10, **dadurch gekennzeichnet, daß** der Träger ein für die Herstellung von Offsetdruckplatten geeignetes Blech, Band oder eine Folie aus Metall, insbesondere aus Aluminium oder einer Aluminiumlegierung, ist, das gegebenenfalls vorbehandelt ist.

12. Aufzeichnungsmaterial nach Anspruch 10, **dadurch gekennzeichnet, daß** der Träger ein für die Herstellung von Farbprüffolien geeignete transparente, flexible und dimensionsstabile Kunststoffolie, bevorzugt eine Polyester- oder Polycarbonatfolie, ist.

13. Verfahren zur Herstellung einer Farbprüffolie mit den Schritten
(a) Zurverfügungstellen eines Materials mit einem UV/VIS-transparenten Träger, einer darauf befindlichen photopolymerisierbaren Schicht, die mit Farbstoffen oder Pigmenten in einer Grundfarbe eingefärbt ist, und einer auf dieser Schicht befindlichen Haftschicht,
(b) Aufbringen einer thermosensitiven Schicht aus einem Gemisch nach einem oder mehreren der Ansprüche 1 bis 9 auf die Rückseite des transparenten Trägers,
(c) Auflaminieren des so hergestellten Mehrschichtmaterials auf ein Bildempfangsblatt, wobei die Haftschicht dem Bildempfangsblatt zugewandt ist,
(d) bildmäßiges Bestrahlen der thermosensitiven Schicht mit IR-Strahlung,
(e) Ausbilden einer Belichtungsmaske durch Entfernen der nichtbestrahlten Bereiche der thermosensitiven Schicht,
(f) ganzflächiges Bestrahlen mit UV/VIS-Strahlung durch die Belichtungsmaske und
(g) Abziehen des transparenten Trägers mit der Maske und den bestrahlten und daher polymerisierten Bereichen der photopolymerisierbaren Schicht und gegebenenfalls
(h) Wiederholen der Schritte (a) bis (g) mit einem Material, dessen photopolymerisierbare Schicht in einer anderen Grundfarbe eingefärbt ist, wobei dieses auf das bereits ein Teilfarbenbild tragende Bildempfangsblatt auflaminiert wird.

## Claims

1. Negative-working, radiation-sensitive mixture containing an organic polymeric binder and a substance which converts radiant energy into heat, **characterised in that** the polymeric binder essentially comprises units of the formula (I) 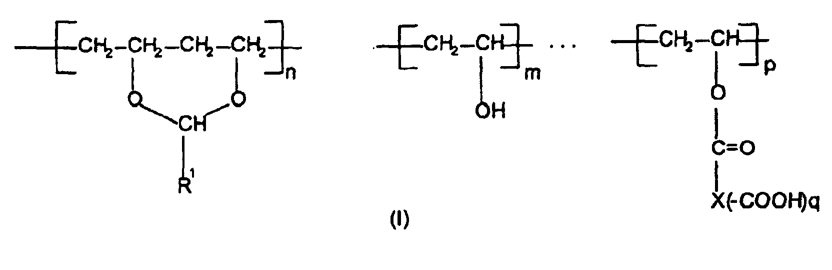 wherein
R¹ represents a hydrogen atom or a (C₁-C₄)alkyl radical,
X represents a single bond or a (q+1)-valent radical of a (C₄-C₁₀)alkane, in which individual methylene groups may be replaced by heteroatoms, of a (C₂-C₈)alkene or of an isocyclic or heterocyclic, saturated or unsaturated, mono- or polycyclic (C₆-C₁₀) ring or ring system,
n is ranging from 40 to 80 mole %,
m is ranging from 15 to 30 mole %,
p is ranging from 1 to 10 mole % and
q is an integer from 1 to 3, q being equal to 1 when X is a single bond,
and the polymeric binder has an acid number of from 5 to 150.

2. The radiation-sensitive mixture as claimed in claim 1, wherein the average molecular weight M_{w} of the polymer of the formula (I) is ranging from 5000 to 500,000, preferably from 20,000 to 300,000.

3. The radiation-sensitive mixture as claimed in claim 1, wherein said polymeric binder contains a residual fraction of polyvinyl acetate units which generally accounts for up to about 6 mole %, in particular from 1 to 4 mole %, based on all monomer units in the binder.

4. The radiation-sensitive mixture as claimed in claim 1, wherein said binder is in general present in an amount ranging from 30 to 95, preferably from 45 to 70% by weight, based on the total weight of the non-volatile constituents of the radiation-sensitive layer.

5. The radiation-sensitive mixture as claimed in claim 1, wherein said constituent capable of converting IR radiant energy into heat is carbon black, a cyanine dye, a merocyanine dye, an infrared-absorbing indolenine dye, indocyanine dye, squarylium dye, methine dye, cyan dye, a pyrylium compound or a pentamethinethiopyrylium salt.

6. The radiation-sensitive mixture as claimed in claim 5, wherein the infrared-absorbing and heat-generating (coloured) pigment is predispersed in a polymeric binder having the units stated in the formula (I).

7. The radiation-sensitive mixture as claimed in claim 5, wherein the amount of said constituent which converts IR radiation into heat in general ranges from 2 to 70% by weight, preferably from 30 to 55% by weight, based on the total weight of the non-volatile constituents of the radiation-sensitive layer.

8. The radiation-sensitive mixture as claimed in claim 1, which optionally contains solubility inhibitors in an amount ranging from 2 to 30% by weight, preferably from 4 to 12% by weight, based on the weight of the non-volatile constituents of the layer.

9. The radiation-sensitive mixture as claimed in claim 1, which contains, as solubility accelerators and reaction accelerators, acids such as phosphoric acid, trimellitic acid, nitrobenzenecarboxylic acids or p-toluenesulphonic acid, as well as trihalomethyl-s-triazines, bistrihalomethyl-s-triazines or acid chlorides, such as 2-diazo-1,2-naphthoquinone-4-sulphonyl chloride, in an amount ranging from 0.5 to 25% by weight, preferably from 2 to 15% by weight, based on the total weight of the non-volatile constituents of the radiation-sensitive layer.

10. A recording material comprising a substrate and a radiation-sensitive layer, wherein said layer comprises a mixture as defined in one or more of claims 1 to 9.

11. The recording material as claimed in claim 10, wherein said substrate is a metal sheet, band or foil, in particular of aluminium or an aluminium alloy, suitable for the production of offset printing plates that optionally has been pre-treated.

12. The recording material as claimed in claim 10, wherein said substrate is a transparent, flexible and dimensionally stable plastic film suitable for the production of colour proofing sheets, preferably a polyester or polycarbonate film.

13. A process for the production of a colour proofing sheet comprising the steps of
(a) providing a material comprising a UV/VIS-transparent substrate, a photopolymerisable layer present thereon and coloured with dyes or pigments in a primary colour and an adhesive layer present on this layer,
(b) applying a heat-sensitive layer comprising a mixture as defined in one or more of claims 1 to 9 to the back of the transparent substrate,
(c) laminating the multilayer material thus produced to an image-receiving sheet, the adhesive layer facing the image-receiving sheet,
(d) imagewise exposing the heat-sensitive layer to IR radiation,
(e) forming an exposure mask by removal of the non-exposed parts of the heat-sensitive layer,
(f) overall exposing to UV/VIS radiation through the exposure mask and
(g) peeling off the transparent substrate together with the mask and the exposed and therefore polymerised parts of the photopolymerisable layer and, optionally,
(h) repeating the steps (a) to (g) with a material the photopolymerisable layer of which has been coloured in another primary colour, said material being laminated to the image-receiving sheet already carrying an image in a primary colour.

## Revendications

1. Mélange sensible à un rayonnement, à traitement négatif, qui contient un liant polymère organique et une substance qui transforme l'énergie rayonnante en chaleur, **caractérisé en ce que** le liant polymère est constitué essentiellement par des unités répondant à la formule (I) 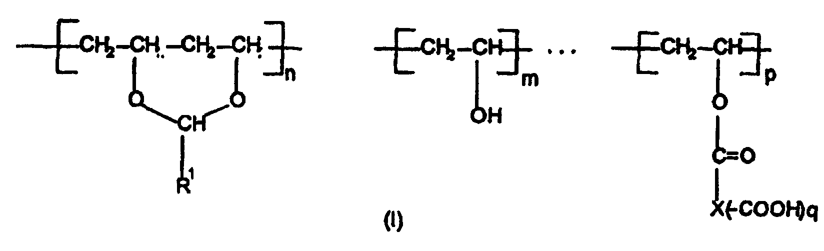 dans laquelle
R¹ représente un atome d'hydrogène ou un groupe alkyle en C₁-C₄ ;
X représente une liaison simple ou un radical à valence (q+1) d'un alcane en C₄-C₁₀, dans lequel des groupes méthylène individuels peuvent être remplacés par des hétéroatomes, d'un alcène en C₂-C₈ ou d'un cycle ou d'un système cyclique en C₆-C₁₀ isocyclique ou hétérocyclique, saturé ou insaturé, monocyclique ou polycyclique,
n représente de 40 à 80 moles % ;
m représente de 15 à 30 moles % ;
p représente de 1 à 10 moles % ; et
q représente un nombre entier de 1 à 3, q étant égal à 1 lorsque X représente une liaison simple ;
et le liant polymère présente un indice d'acide de 5 à 150.

2. Mélange sensible à un rayonnement selon la revendication 1, **caractérisé en ce que** le poids moléculaire moyen M_{W} du polymère répondant à la formule I s'élève de 5000 à 500.000, de préférence de 20.000 à 300.000.

3. Mélange sensible à un rayonnement selon la revendication 1, **caractérisé en ce que** le liant polymère contient une fraction résiduelle d'unités d'acétate de polyvinyle, qui représente en général jusqu'à environ 6 moles %, en particulier de 1 à 4 moles %, rapportés à toutes les unités monomères dans le liant.

4. Mélange sensible à un rayonnement selon la revendication 1, **caractérisé en ce que** la fraction du liant représente en général de 30 à 95, de préférence de 45 à 70 % en poids, rapportés au poids total des constituants non volatils de la couche sensible à un rayonnement.

5. Mélange sensible à un rayonnement selon la revendication 1, **caractérisé en ce que** le composant qui est en mesure de transformer en chaleur l'énergie rayonnante dans le domaine infrarouge du spectre est du noir de carbone, un colorant de cyanine, un colorant de mérocyanine, un colorant d'indolénine absorbant dans la région infrarouge du spectre, un colorant d'indocyanine, un colorant de squarylium, un colorant de méthine, un colorant bleu-vert, un composé de pyrylium ou un sel de pentaméthinethiopyrylium.

6. Mélange sensible à un rayonnement selon la revendication 5, **caractérisé en ce que** le pigment (chromogène) absorbant dans la région infrarouge du spectre et générant de la chaleur est soumis à une mise en dispersion préalable dans un liant polymère avec les unités mentionnées dans la formule (I).

7. Mélange sensible à un rayonnement selon la revendication 5, **caractérisé en ce que** la fraction du composant qui transforme le rayonnement infrarouge en chaleur représente en général de 2 à 70 % en poids, de préférence de 30 à 55 % en poids, chaque fois rapportés au poids total des constituants non volatils de la couche sensible à un rayonnement.

8. Mélange sensible à un rayonnement selon la revendication 1, **caractérisé en ce qu'**il contient, le cas échéant, des inhibiteurs de la solubilité en une fraction de 2 à 30 % en poids, de préférence de 4 à 12 % en poids, chaque fois rapportés au poids des constituants non volatils de la couche.

9. Mélange sensible à un rayonnement selon la revendication 1, **caractérisé en ce qu'**il contient, à titre d'accélérateurs de la solubilité et d'accélérateurs de la réaction des acides tels que l'acide phosphorique, l'acide trimellitique, des acides nitrobenzènecarboxyliques ou l'acide p-toluènesulfonique, mais encore des trihalogénométhyl-s-triazines, des bis-trihalogéno-s-triazines ou encore des chlorures d'acides tels que le chlorure de l'acide 1,2-naphtoquinone-2-diazide-4-sulfonique en une fraction de 0,5 à 25 % en poids, de préférence de 2 à 15 % en poids, chaque fois rapportés au poids total des constituants non volatils de la couche sensible à un rayonnement.

10. Matériau d'enregistrement comprenant un support et une couche sensible à un rayonnement, **caractérisé en ce que** la couche est constituée d'un mélange selon une ou plusieurs des revendications 1 à 9.

11. Matériau d'enregistrement selon la revendication 10, **caractérisé en ce que** le support est constitué d'une tôle, d'une bande ou d'une feuille en métal, en particulier en aluminium ou en alliage d'aluminium, appropriées pour la fabrication de clichés d'impression offset, le métal ayant été, le cas échéant, soumis à un traitement préalable.

12. Matériau d'enregistrement selon la revendication 10, **caractérisé en ce que** le support est constitué d'une feuille en matière synthétique transparente, flexible et manifestant une stabilité dimensionnelle, de préférence une feuille de polyester ou de polycarbonate, appropriée pour la fabrication de feuilles d'épreuves couleurs.

13. Procédé pour la fabrication d'une feuille d'épreuve couleur possédant les étapes consistant à :
(a) procurer un matériau comprenant un support manifestant une transparence pour le rayonnement ultraviolet/la lumière visible, une couche photopolymérisable par-dessus le premier cité, ladite couche étant colorée en une couleur de base avec des colorants ou des pigments, et une couche adhésive disposée sur la dernière citée ;
(b) appliquer une couche thermosensible constituée d'un mélange selon une ou plusieurs des revendications 1 à 9, sur le côté dorsal du support transparent ;
(c) contrecoller le matériau multicouche ainsi obtenu sur une feuille de réception d'image, la couche adhésive étant tournée vers la feuille de réception d'image ;
(d) exposer en forme d'image la couche thermosensible à un rayonnement infrarouge ;
(e) réaliser un masque d'exposition par élimination des zones non exposées de la couche thermosensible ;
(f) procéder à une exposition s'étendant sur toute la surface avec un rayonnement ultraviolet/de lumière visible à travers le masque d'exposition ; et
(g) pelliculer le support transparent avec le masque et avec les zones exposées, par conséquent polymérisées, de la couche photopolymérisable ; et, cas échéant
(h) répéter les étapes (a) à (g) avec un matériau dont la couche photopolymérisable a été colorée en une autre couleur de base, ledit matériau étant stratifié sur la feuille de réception d'image portant déjà une image de sélection partielle.
